# EUROPEAN PATENT APPLICATION

(11) **EP 2 392 951 A1**
(43) Date of publication of application: **07.12.2011**
(21) Application number: 10735496.1
(22) Date of filing: 26.01.2010
(51) Int. Cl.: G02B 5/28, G02B 6/34, H01L 27/148, H01S 5/00, C03C 23/00

(54) **METHOD FOR OBTAINING A FLEXIBLE BRAGG MIRROR AND BRAGG MIRROR OBTAINED USING SAID METHOD**

(30) Priority: 30.01.2009 ES 200900275
(71) Applicant: Consejo Superior de Investigaciones Cientificas (CSIC), 28006 Madrid (ES)
(72) Inventor: MÍGUEZ GARCÍA, Hernán Ruy, E-41092 Sevilla (ES); CALVO ROGGIANI, Mauricio Ernesto, E-41092 Sevilla (ES)
(74) Representative: Ungria Lopez, Javier
(86) International application number: PCT/ES2010/070044
(87) International publication number: WO 2010/086483

(57) **Abstract**

The main object of the present invention is a method for obtaining a flexible Bragg mirror (1') from a photonic crystal consisting of a rigid porous multilayer (1), the method comprising filling with a polymer the pores of the porous multilayer (1) to provide it with mechanical stability.

## Description

### OBJECT OF THE INVENTION

The main object of the present invention is a method for obtaining a flexible Bragg mirror from a photonic crystal consisting of a rigid porous multilayer. The flexible Bragg mirror obtained maintains the reflective properties of the starting photonic crystal and, being flexible, it can be used to coat objects of any shape. In addition, the optical properties of this mirror make It possible to act as an interference optical filter. Another object of the invention is directed to the Bragg mirror obtained by the above method.

### BACKGROUND OF THE INVENTION

A Bragg mirror is a structure consisting of an alternating sequence of layers of two optical materials of different refractive indices having a high reflectivity to electromagnetic radiation of a given wavelength if the repetition period corresponds to approximately half said wavelength.

The wavelength reflected by a Bragg mirror is really a band of wavelengths, called the band gap, the position of which depends on the values of the refractive index of the sheets that make up the mirror and the thickness of said sheets. The spectral width of this band depends on the contrast between the refractive indices of these sheets. In a second approach, the number of layers present in the mirror will also influence both the position and the width of this band. The more the number of layers, the higher the reflectivity of the mirror.

One of the applications of these materials is the protection of objects against radiation of a certain wavelength, or providing the objects with a desired color. Moreover, as this effect has a structural origin, heating is prevented due to the absorption of radiation. However, most of the Bragg mirrors are flat and stiff, which greatly limits their field of application.

Although in recent years there has been some progress, it has not yet been possible to solve the problem completely. One of the obstacles of the manufacturing of flexible Bragg mirrors is the difficulty of finding materials that simultaneously have a periodic modulation of its refractive index at a submicron scale and also a mechanically stable flexible structure.

As an example, photonic structures obtained from two different organic compounds, may be mentioned. Such is the case of layered structures obtained by self-assembly of homopolymers and copolymers ("Tunable Block Copolymer/Homopolymer Photonic Crystals", Urbas et al. Advanced Materials 2000, 12, 812*)*; or infiltration of a porous network of an artificial opal of polystyrene spheres with an elastomer to form a "photonic paper" ("Photonic Papers and Inks: Color Writing with Colorless Materials", H. Fudouzi et al. Advanced Materials 2003, 15, 892*).* However, in all these cases, since only organic compounds are being used, the dielectric contrast is low and a possible subsequent heat treatment is not possible.

### DESCRIPTION OF THE INVENTION

A first aspect of the present patent application describes a method for obtaining high dielectric contrast, flexible Bragg mirrors from photonic crystals consisting of a rigid porous multilayer. In the present document, the term "Bragg mirrors" is also intended to be related to optical Interference filters, and In general to any structure with reflectivity optical properties similar to those of the Bragg mirrors.

Basically, the method of the invention consists of filling with a polymer the holes of the starting rigid porous multilayer, thereby providing it with a mechanical strength that allows, if necessary, separating it from the substrate on which it has been formed and then attaching it to a surface with an arbitrary shape. The polymer used must have the suitable mechanical properties to provide the multilayer photonic crystal with enough mechanical stability and flexibility that allows it to coat objects of any shape. The flexible Bragg mirror obtained has broad reflection (^{Δλ}/_{λ}≈40%) and high intensity (*I*ₘₐₓ ≈ 70%) peaks. Moreover, its spectral position can be adjusted precisely by changing the parameters of the internal structure of the starting multilayer photonic crystal.

Two strategies can be used to fill the pores of the starting multilayer photonic crystal with the polymer:
a) The first strategy consists of introducing a polymer dissolved in a suitable solvent in the rigid porous multilayer, and then extracting the solvent. Obviously, the solution must have the appropriate properties, for example surface tension and viscosity, to infiltrate into the pores of the multilayer structure, and also the polymer used must be soluble. Examples of suitable polymers are polycarbonate, polydimethylsiloxane, polymethyl methacrylate, polyvinylpyrrolidone and polystyrene.
   Thus, the operations of the method according to this first strategy are the following:
   1) Impregnating the porous multilayer with a polymer solution.
      In this first operation, the porous multilayer is wet with the polymer solution until it completely infiltrates in the holes of the structure. As mentioned above, it is important that the surface tension and the viscosity of the solution are low enough to fully infiltrate in the holes. This can be achieved by maintaining the temperature within some adequate ranges, which will depend in each case on the polymer solution used, or even by using surfactants. 2) Evenly distributing the polymer solution through the pores of the multilayer.
      The more evenly distributed the compounds are through the holes of the porous structure, the better the results of the method will be. Therefore, in a preferred embodiment of the invention the techniques of spin-coating, dip-coating or doctor blade are employed, which in addition to contributing to the distribution of the solution through the structure, create an outer coating with a very small thickness that provides the porous multilayer with an even greater mechanical stability. 3) Completely evaporating the solvent embedded in the porous multilayer.
      It is necessary to achieve complete evaporation of the solvent so that in the structure there is only the solidified polymer. For this purpose, in a particular embodiment of the invention the multilayer is heated for a period of time and at a temperature suitable and known in the art depending on the solvent used.
b) The second strategy consists of carrying out the polymerization of a monomer, dimer or oligomer previously infiltrated together with a curing agent in the starting multilayer photonic crystal. In this case, the polymerization should be uniform and complete in all the photonic crystal for the mechanical properties to be unvarying. This method is applicable to any polymer that can be synthesized from a monomer, dimer or oligomer that can be infiltrated and polymerized in the interior of the multilayer, Examples of suitable monomers, dimers or oligomers are different chain dimethyl siloxane, methyl methacrylate and vinyl chloride.
   The operations of the method according to this second strategy are:
   1) Impregnating the porous multilayer with a mixture of monomers, dimers or oligomers and a suitable curing agent.
      In this first operation, the porous multilayer is wet with a mixture with appropriate amounts of monomer, dimer or oligomer and the curing agent until it infiltrates completely into the holes of the structure. As mentioned above, it is important that the surface tension and viscosity are low enough to fully infiltrate into the gaps. This can be achieved by maintaining the temperature within suitable ranges, which will depend in each case on the polymer solution used, or even by using surfactants.
   2) Evenly distributing the mixture of monomers, dimers or oligomers and curing agent through the pores of the multilayer.
      The more evenly the mixture is distributed through the holes of the porous structure, the better the results of the method. Therefore, in a preferred embodiment of the invention the techniques of spin-coating, dip-coating or doctor blade are used which, in addition to contributing to the distribution of the mixture through the structure, create an outer coating of very small thickness that provides the porous multilayer with an even greater mechanical stability.
   3) Polymerizing the oligomers. For this purpose, in a particular embodiment of the invention the multilayer is heated for a period of time and at a temperature suitable and known in the art depending on the polymer used and the curing agent.

In addition, the starting multilayer photonic crystal used to carry out to the method of the invention can be any type of multilayer structure that has pores in its structure that can be filled with the polymer. For example, it may be a photonic crystal with a multilayer structure consisting of nanoparticles, obtained, for example, by deposition on a substrate. In preferred embodiments of the invention, the porous multilayer Is composed of layers of metal oxide, metal, semiconductor or polymer nanoparticles, and most preferably titanium oxide and silicon oxide.

Throughout this method the optical quality of the starting multilayer photonic crystal, which only suffers minor alterations, is maintained. In the case that it is attached to a substrate, the last operation of the method is to separate the flexible Bragg mirror recently manufactured from the substrate. In another preferred embodiment of the invention, it is possible to heat the Bragg mirror, once adhered to an object with an arbitrary shape, to a temperature sufficient to melt the polymer embedded In the holes of its structure. Thus, the polymer is extracted leaving the original structure, prior to the method of the invention.

A second aspect of the invention is directed to a Bragg mirror manufactured according to the method described above, comprising a porous multilayer the pores of which are filled with a polymer to provide mechanical stability.

### DESCRIPTION OF THE FIGURES

To complement the description being made and in order to help to better understand of the features of the invention, according to a preferred example of practical embodiment thereof. A set of figures where, with an illustrative and not limiting character is attached as an integral part of said description. The following has been represented:
Figure 1.- Shows a view of the cross section of a multilayer photonic crystal consisting of nanoparticles before undergoing the method of the invention.
Figure 2.- Shows a view of the cross section of the multilayer photonic crystal of Figure 1 with the polymer embedded in holes of its structure.
Figure 3.- Shows a view of the multilayer photonic crystal of the previous figures after being mechanically separated from the substrate,
Figure 4.- Shows a view of the multilayer photonic crystal of the previous figures once adhered to an arbitrary surface object.
Figure 5.- Shows a view of the multilayer photonic crystal attached to an arbitrary surface object and after extracting the polymer from the holes of its structure.
Figure 6.- Shows an view of scanning electron microscopy (SEM) of the cross section of a multilayer photonic crystal infiltrated with poly (bisphenol-A carbonate). The scales are 500 nm and 100 nm for (a) and (b) respectively.
Figure 7.- Shows an electron microscopy Image of the cross section of a multilayer photonic crystal infiltrated with PDMS.
Figure 8.- shows the specular reflectance spectra obtained for multilayer photonic crystals with different periodicity and infiltrated with polycarbonate and detached from the glass substrate.
Figure 9.- Shows an electron microscopy image of the cross section of a multilayer photonic crystal infiltrated with PDMS. The scales are 500 nm and 100 nm for (a) and (b) respectively.
Figure 10.- (a) shows an electron microscopy image of the cross section of a multilayer photonic crystal transferred to a substrate and heat treated at 450° C. The scale corresponds to 500 nm. (b) Specular reflectance spectra of a multilayer transferred on a glass substrate (black dotted line), and treated at 450° C (orange solid line) and then this infiltrated with ethanol (red segmented line).
Figure 11.- shows the transmittance spectra obtained for multilayer photonic crystals detached from the glass substrate and with different periodicity and infiltrated with subsequently polymerized PDMS oligomers.

### PREFERRED EMBODIMENT OF THE INVENTION

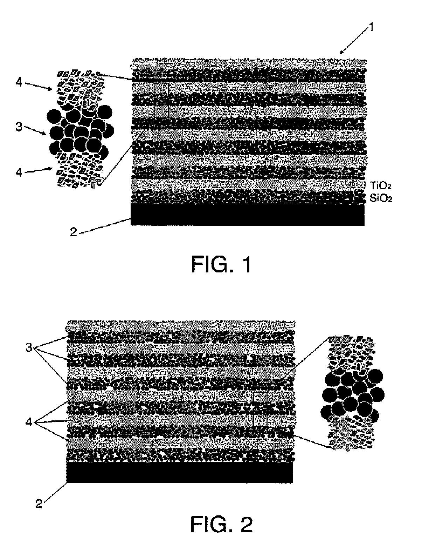

Next an example of a method for each of the strategies described in accordance with the invention is described, In both cases we started from a photonic crystal formed by a porous multilayer (1) formed by nanoparticles of silicon oxide (SiO₂) and titanium oxide (TiO₂). In particular, it is a porous multilayer (1) of 12 layers manufactured by deposition on a glass substrate (2), shown in Figure 1, being able to see in the detail located to its left how the layer of TiO₂ (4) penetrates in the layer of SiO₂ (3).

### Strategy 1

First, the photonic crystal formed by the porous multilayer (1) is impregnated with a 5% solution of poly (bisphenol-A carbonate) in methylene chloride at a temperature of 30° C ± 2° C. It is crucial to maintain the temperature within this range to ensure that the solution reaches all the nanosized holes of the porous multilayer (1), since at lower temperatures its viscosity prevents total infiltration, and at higher temperatures the solvent evaporation Is too fast, also preventing proper diffusion of poly (bisphenol-A carbonate.

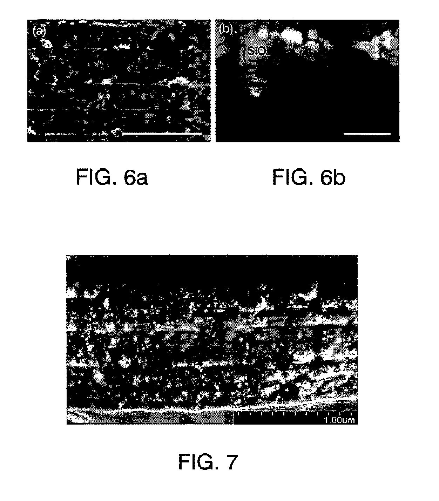

Next, a spin-coating treatment at 6000 rpm for 40 seconds is applied to achieve even distribution of the solution throughout the structure of the porous multilayer (1). Figure 2 shows how the solution, plotted in light gray in the detailed view, fills the holes of the structure of the porous multilayer (1). A SEM image of the infiltrated cross section and the detailed view of the Interface between layers are shown in Figures 6a and 6b.

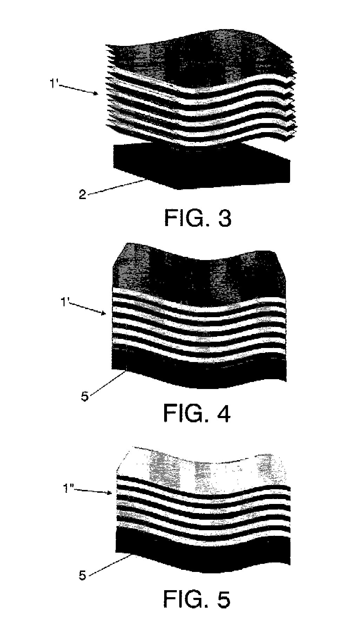

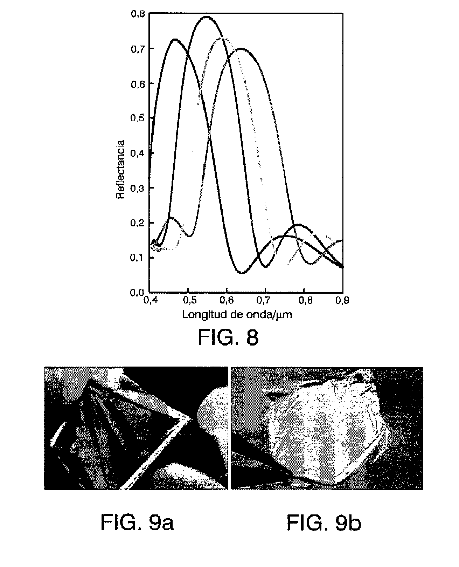

Subsequently, the photonic crystal formed by the porous multilayer (1) is heated at 60° C for 2 hours to achieve a complete evaporation of the solvent and is separated from the glass substrate (2) by mechanical means. The Bragg mirror (1') obtained by this method maintains the optical properties of the starting porous multilayer (1), such as is shown in Figure 8 for photonic crystals with different periodicity. On the other hand, the flexibility obtained allows it to be applied to objects of any shape. In particular. Figure 3 shows how the Bragg mirror (1') obtained is mechanically separated from the glass substrate (2) and attached to an object (5) with an arbitrary shape in Figure 4. An image of photography of the detachment process and its subsequent bonding onto another surface is shown in Figures 9a and 9b.

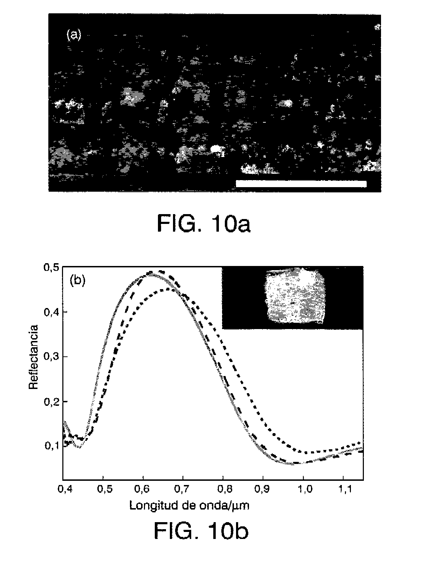

Finally, Figure 5 shows how, after a heating step that has served to melt and extract the polymer from its inside, the obtained Bragg mirror (1") has recovered the original structure of the photonic crystal formed by the porous multilayer (1) from which we started at the beginning of the method. The absence of the polymer has been represented In Figure 5 because the lighter color it had in Figure 1 is recovered. Figure 10a) shows an SEM image of the cross section of the photonic crystal transferred to an arbitrary surface and treated at 450° C. Figure 10b) shows the optical properties of the crystal prior to being heat-treated (dotted line), after being treated (solid line) and then infiltrated with ethanol (segmented line).

### Strategy 2

First, a 10:1 mixture of vinyl functional groups-terminated siloxane oligomers (oligomers) and cross-linked chain siloxane oligomers (curing agent) is carried out. This mixture is spread on a photonic crystal, using the doctor-blade method. If a smaller final thickness of polymer is preferred, a spin-coating treatment at 1200 rpm for 60 seconds is applied.

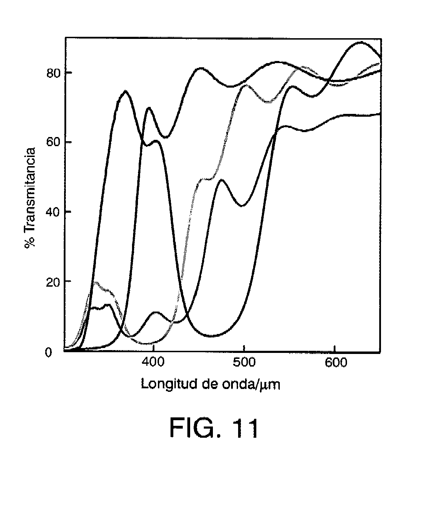

Next the infiltrated multilayer is heated at 120° C for 20 minutes to carry out the polymerization of siloxane to polydimethylsiloxane (PDMS). Finally it is allowed to cool and the whole system is immersed in liquid nitrogen to increase the stiffness of PDMS and detach the infiltrated multilayer from the substrate. Figure 7 shows an electron microscopy image of the cross section of a multilayer formed by nanoparticles and infiltrated by this method. The transmittance spectra of the films detached are shown in Figure 11,

## Claims

1. Method for obtaining a flexible Bragg mirror (1') from a photonic crystal formed by a rigid porous multilayer (1), **characterized in that** it comprises filling the pores of the porous multilayer with a polymer, to provide it with mechanical stability.

2. Method for obtaining a flexible Bragg mirror (1') according to claim 1, **characterized in that** the operation of filling the pores of the porous multilayer (1) with a polymer in turn comprises:
infiltrating the porous multilayer (1) with a polymer solution;
evenly distributing the polymer solution through the porous multilayer (1), and
heating the porous multilayer (1) until the evaporation of the solvent is obtained.

3. Method for obtaining a flexible Bragg mirror (1') according to claim 2, **characterized in that** the operation of evenly distributing the polymer solution through the porous multilayer (1) is carried out by using one of the methods listed below: spin-coating, dip-coating and doctor blade.

4. Method for obtaining a flexible Bragg mirror (1') according to any of claims 2-3. **characterized in that** the polymer solution comprises a polymer from the following list: polycarbonate, polydimethylsiloxane, polymethyl methacrylate, polyvinylpyrrolidone and polystyrene.

5. Method for obtaining a flexible Bragg mirror (1') according to claim 1. **characterized in that** the operation of filling the pores of the porous multilayer (1) with a polymer in turn comprises:
infiltrating the porous multilayer (1) with a mixture of monomers, dimers or oligomers and a curing agent;
evenly distributing the mixture through the porous multilayer (1);
heating the porous multilayer (1) to achieve polymerization of monomers, dimers or oligomers.

6. Method for obtaining a flexible Bragg mirror (1') according to claim 5, **characterized in that** the operation of evenly distributing the mixture through the porous multilayer (1) is carried outby using one of the methods listed below: spin-coating, dip-coating and doctor blade.

7. Method for obtaining a flexible Bragg mirror (1') according to any of claims 5-6, **characterized in that** the monomers, dimers or oligomers of the mixture are chosen from the following list: different chain dimethyl siloxane, methyl methacrylate and vinyl chloride.

8. Method for obtaining a flexible Bragg mirror (1') according to any of the preceding claims, **characterized in that** it further comprises the operation of:
detaching the flexible Bragg mirror (1') from a substrate (2) to which it is fixed.

9. Method for obtaining a flexible Bragg mirror (1') according to claim 8, **characterized in that** it further comprises the operation of adhering the flexible Bragg mirror (1') to an object (5) with an arbitrary shape.

10. Method for obtaining a flexible Bragg mirror (1') according to claim 9, **characterized in that** it further comprises the operation of:
heating the Bragg mirror (1') attached to the object (5) to melt the polymer embedded in the pores of its structure.

11. Method for obtaining a flexible Bragg mirror (1') according to any of the preceding claims, **characterized in that** the starting porous multilayer (1) is composed of layers of metal oxides, metals, semiconductors or polymers nanoparticles.

12. Method for obtaining a flexible Bragg mirror (1') according to claim 11, **characterized in that** the metal oxides are SiO₂ (3) and TiO₂ (4).

13. Flexible Bragg mirror (1') manufactured according to the method of any of the preceding claims, comprising a porous multilayer (1) the pores of which are filled with a polymer to provide it with mechanical stability.
